(19) Europäisches Patentamt
European Patent Office
Office européen des brevets

(11) **EP 2 661 814 B1**

(12) **FASCICULE DE BREVET EUROPEEN**

(45) Date de publication et mention de la délivrance du brevet:
**15.11.2017 Bulletin 2017/46**

(21) Numéro de dépôt: **12700063.6**

(22) Date de dépôt: **03.01.2012**

(51) Int Cl.:
*H03M 13/29* *(2006.01)*   *H03M 13/39* *(2006.01)*
*H03M 13/41* *(2006.01)*

(86) Numéro de dépôt international:
**PCT/EP2012/050046**

(87) Numéro de publication internationale:
**WO 2012/093115 (12.07.2012 Gazette 2012/28)**

(54) **PROCÉDÉ DE DÉCODAGE ET DÉCODEUR**

DEKODIERVERFAHREN UND DEKODIERER

DECODING METHOD AND DECODER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.01.2011 FR 1150018**

(43) Date de publication de la demande:
**13.11.2013 Bulletin 2013/46**

(73) Titulaire: **Centre National d'Etudes Spatiales 75039 Paris Cedex 01 (FR)**

(72) Inventeurs:
• **PREVOST, Raoul**
  **F-11200 Saint-Andre de Roquelongue (FR)**
• **BONACCI, David**
  **F-31500 Toulouse (FR)**
• **COULON, Martial**
  **F-31500 Toulouse (FR)**
• **TOURNERET, Jean-Yves**
  **F-31500 Toulouse (FR)**
• **LE MAITRE, Julia**
  **F-31190 Grepiac (FR)**
• **MILLERIOUX, Jean-Pierre**
  **F-31400 Toulouse (FR)**

(74) Mandataire: **Office Freylinger**
  **P.O. Box 48**
  **8001 Strassen (LU)**

(56) Documents cités:
**EP-A1- 1 928 179     US-A1- 2003 028 838**

• PETROVIC D ET AL: "List Viterbi decoding with continuous error detection for magnetic recording", GLOBECOM'01. 2001 IEEE GLOBAL TELECOMMUNICATIONS CONFERENCE. SAN ANTONIO, TX, NOV. 25 - 29, 2001; [IEEE GLOBAL TELECOMMUNICATIONS CONFERENCE], NEW YORK, NY : IEEE, US, vol. 5, 25 novembre 2001 (2001-11-25), pages 3007-3011, XP010747545, DOI: DOI:10.1109/GLOCOM.2001.965979 ISBN: 978-0-7803-7206-1
• JUAN SONG ET AL: "Design and implementation of WTB controller using SOPC technology", SIGNAL PROCESSING, 2008. ICSP 2008. 9TH INTERNATIONAL CONFERENCE ON, IEEE, PISCATAWAY, NJ, USA, 26 octobre 2008 (2008-10-26), pages 2804-2807, XP031369651, DOI: DOI:10.1109/ICOSP.2008.4697730 ISBN: 978-1-4244-2178-7
• BOLLATI G ET AL: "A 450 Mbit/s parallel read/write channel with parity check and 16-state time variant Viterbi", PROCEEDINGS OF THE IEEE 2000 CUSTOM INTEGRATED CIRCUITS CONFERENCE. (CICC 2000). ORLANDO, FL, MAY 21-24, 2000; [IEEE CUSTOM INTEGRATED CIRCUITS CONFERENCE.CICC], vol. CONF. 22, 24 mai 2000 (2000-05-24), pages 319-322, XP002288505, ISBN: 978-0-7803-5810-2
• Bill McDaniel: "An Algorithm for Error Correcting Cyclic Redundancy Checks", Dr.Dobb's Website , 1 juin 2003 (2003-06-01), pages 1-9, XP002647114, Extrait de l'Internet: URL:http://drdobbs.com/web-development/184 401662?cid=dobbs-callout-mostpop [extrait le 2011-07-04] cité dans la demande

• SAWAGUCHI H ET AL: "A concatenated coding technique for partial response channels", IEEE TRANSACTIONS ON MAGNETICS, IEEE SERVICE CENTER, NEW YORK, NY, US, vol. 37, no. 2, pt.1, 1 mars 2001 (2001-03-01), pages 695-703, XP002285557, ISSN: 0018-9464, DOI: DOI:10.1109/20.917603

**Description**

**Domaine technique**

La présente invention concerne un procédé de décodage d'une séquence de symboles, notamment d'une séquence de symboles ayant été obtenue par codage d'un paquet de données contenant un message et un bloc de contrôle de redondance cyclique obtenu à partir du message. L'invention concerne en outre un décodeur ainsi qu'un programme d'ordinateur pour la mise en oeuvre du procédé de décodage.

**Etat de la technique**

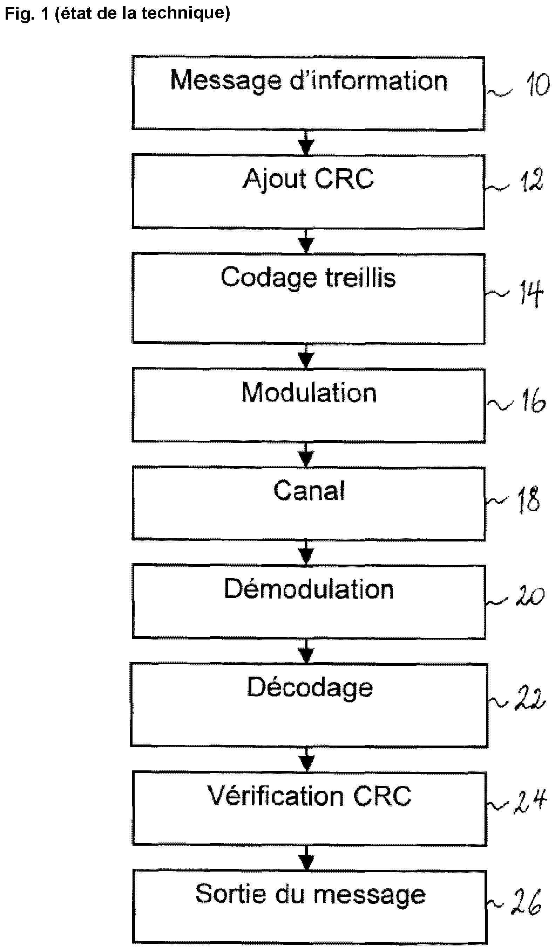

La figure 1 montre une chaîne conventionnelle de transmission. Dans une première étape 12, le message à transmettre 10 (message initial) est utilisé pour calculer un bloc de contrôle de redondance cyclique (CRC). La technique de CRC est communément appliquée pour détecter des erreurs de transmission par ajout de redondance. Le bloc de redondance est rattaché au message initial (par concaténation des séquences binaires du message et du bloc de redondance). Pour contraster le message obtenu par rajout du bloc de redondance ou par une autre transformation préliminaire du message initial, on l'appellera dans la suite « message transformé ». Dans le contexte de ce document, le message initial peut être un message d'information ou tout autre message pouvant être représenté sous forme binaire.
Le bloc de CRC est une séquence binaire de longueur déterminée qui est obtenue par un hachage effectué sur le message initial. Un bloc de CRC de longueur $n$ calculé sur un message initial d'une longueur quelconque permet de détecter toute rafale (en anglais « burst ») d'erreurs d'une longueur qui ne dépasse pas $n$ et une fraction de $1-2^{-n}$ des rafales d'erreurs de longueur plus importante. On calcule le bloc de CRC par division polynomiale modulo 2. A cette fin, on associe au message initial un polynôme de message, ci-après noté $M(x)$. Le bloc de CRC correspond au reste $R(x)$ de la division polynomiale modulo 2 de $M(x) \cdot x^{n+1}$ par le polynôme générateur de degré $n+1$, noté $G(x)$. Le quotient de la division peut être ignoré. Le degré du reste $R(x)$ ne peut être supérieur au degré de $G(x)$ moins un, c.-à-d. à $n$. Le cas échéant, on rajoute des bits 0 au reste $R(x)$ pour avoir un bloc de CRC de longueur fixe. Pour le calcul du bloc de CRC, on peut notamment utiliser un registre à décalage à rétroaction linéaire (en anglais : « linear feedback shift register »). Le paquet de données formé par le message initial auquel on a rattaché son bloc de CRC est parfois appelé « mot de code ».
Le paquet de données composé du message initial et du bloc de CRC est ensuite encodé en treillis (en anglais « trellis coded ») à l'étape 14. Ce codage treillis peut consister en un codage canal, par exemple un codage convolutif, ou être implicite lors de la modulation, par exemple dans le cas d'une modulation à phase continue (encore appelée CPM, de l'anglais « Continuous Phase Modulation »).
On se sert ensuite de la séquence de symboles obtenue par le codage pour moduler (à l'étape de modulation 16) un signal aux fins de la transmission par le canal de transmission 18.
Du côté du récepteur, le signal transmis est démodulé (à l'étape de démodulation 20) de manière cohérente (i.e. en utilisant la connaissance de la phase de la porteuse) ou non cohérente (i.e. sans utiliser la connaissance de la phase de la porteuse) et décodé (à l'étape de décodage 22) par un algorithme de décodage de treillis, tel que, p.ex. à l'aide de l'algorithme de Viterbi, ou encore l'algorithme SOVA (de l'anglais « Soft Output Viterbi Algorithm », algorithme de Viterbi à sortie souple), ou encore l'algorithme BCJR (nommé ainsi à cause de ses inventeurs Bahl, Cocke, Jelinek and Raviv), ou encore un algorithme BCJR simplifié.
Pour détecter et/ou corriger des erreurs de transmission, le récepteur vérifie le CRC du message transmis à l'étape 24 avant de sortir le message vérifié/corrigé (étape 26) ou un message d'erreur au cas où la correction ne serait pas possible. Il y a différentes méthodes connues pour la vérification d'un CRC. Une de ces méthodes consiste à calculer le CRC sur la séquence de bits d'information reçue et de le comparer avec le CRC du message transmis. Une méthode pouvant être plus facilement implémentée en hardware utilise la propriété que le CRC d'une séquence binaire constituée d'un message suivi de son CRC est zéro, ce qui peut être exprimé comme :

$$CRC([\textit{données}, CRC(\textit{données})]) = 0$$

où $CRC(.)$ désigne le résultat du calcul de CRC et $[.,.]$ la concaténation de deux séquences binaires. Selon cette méthode, on calcule donc le CRC du message transmis (c.-à-d. sur l'ensemble des bits d'information et des bits de redondance obtenu suite au décodage). Si le résultat est 0, le message est considéré transmis correctement. Il existe aussi des méthodes permettant de détecter l'emplacement d'un bit erroné. Une telle méthode est notamment décrite dans l'article de B. McDaniel, « An algortithm for error correcting cyclic redundancy checks, » C/C++ Users Journal, p. 6, 2003. Des développements de cette méthode permettent de corriger plusieurs bits erronés (voir p.ex. S. Babaie, A. K. Zadeh, S. H. Es-hagi, N. J. Nvimipour, « Double bits error correction using CRC method, » International Conférence on Semantics, Knowledge and Grid, no 5, pp. 254-257, 2009 et C. Shi-yi and L. Yu-bai, « Error correcting cycle redundancy checks based on confidence declaration, » ITS Télécommunications Proceedings, no 6, pp. 511-514, 2006, ou aussi G. Bollati et AL: "A 450 Mbit/s parallel read/write channel with parity check and 16-state time variant Viterbi",Proceedings og the IEEE 2000 Custom Integrated Circuits Conference, CICC 2000, ORLANDO, FL, May 21-24, 2000; vol. CONF. 22 , pages 319-322).

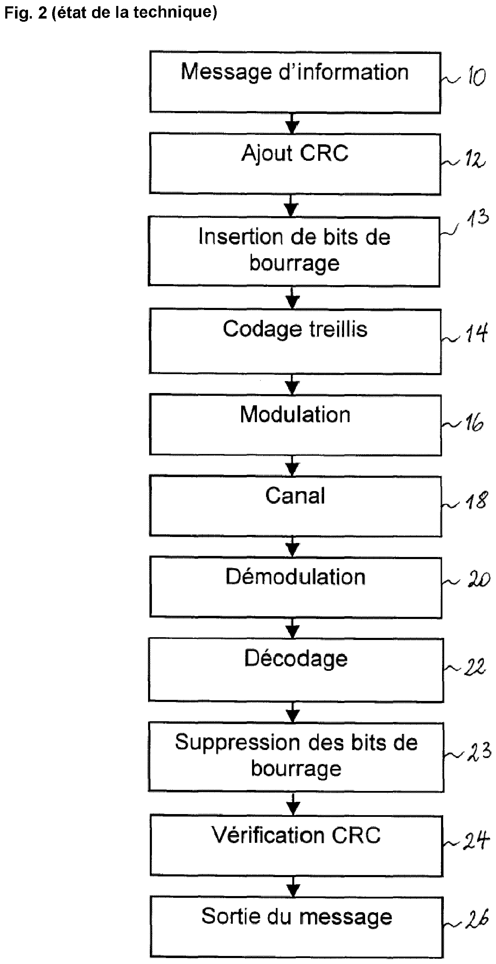

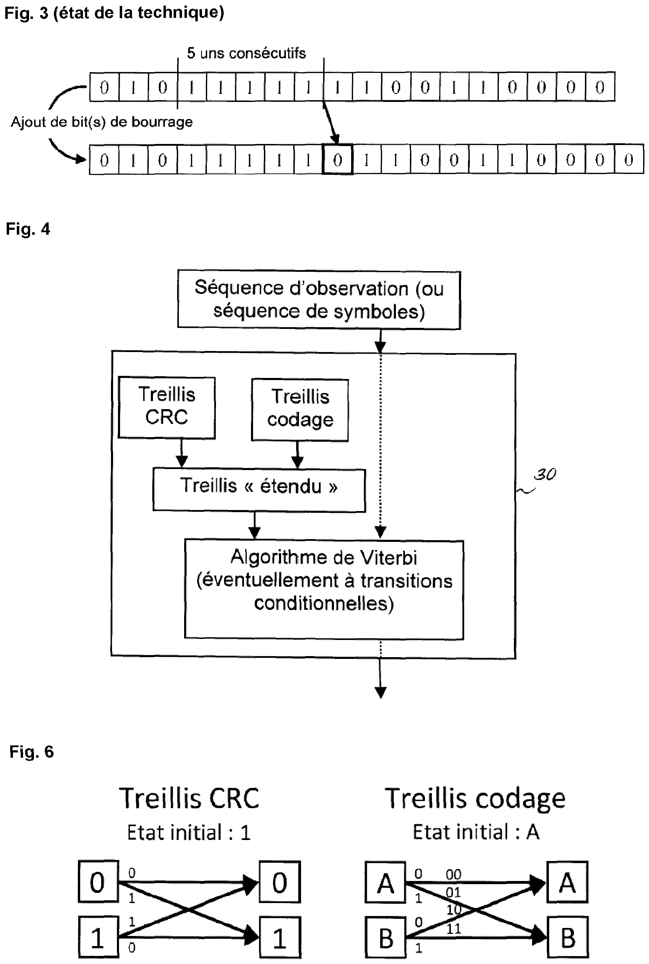

La figure 2 montre une chaîne conventionnelle de transmission qui se distingue de celle de la figure 1 par le fait que des bits de bourrage (en anglais « stuffing bit » ou « stuffed bit »), qui ne représentent pas d'information ou de redondance, sont insérés dans le message transformé (étape 13). Ces bits de bourrage sont typiquement utilisés pour limiter le nombre de bits consécutifs de la même valeur et introduire des transitions supplémentaires. Les transitions supplémentaires servent notamment à réduire des problèmes de synchronisation au niveau du récepteur ou à éviter l'occurrence de séquences binaires à signification spécifique (telles que des séquences de contrôle, par exemple). Le protocole HDLC (sigle anglais pour « High-level Data Link Control », protocole de liaison de données de niveau 2) se sert de bits de bourrage pour éviter l'apparition du drapeau de fin de trame (qui correspond dans le cas de HDLC à la séquence binaire 01111110). Selon le protocole HDLC, un bit 0 est inséré derrière une séquence de cinq bits consécutifs de valeur 1, ce qui garantit que le drapeau de fin de trame n'apparaît pas au milieu d'un message. Ceci est illustré à la figure 3. Les bits de bourrage peuvent être de valeur 0 et/ou de valeur 1, selon les spécifications du protocole considéré. Dans les cas de HDLC ou d'AIS (sigle anglais pour « Automatic Identification System », système d'identification automatique), les bits de bourrage sont toujours des bits de valeur 0. Notons encore que le concept de l'insertion de bits de bourrage ne doit pas être confondu avec le concept de remplissage (en anglais « padding ») qui consiste en l'insertion de bits pour atteindre une longueur de séquence binaire prédéterminée. Pour retrouver le message initial, les bits de bourrage sont éliminés (étape 23) après le décodage, mais avant la vérification du CRC, car le bloc de CRC ne tient pas compte de bits de bourrage éventuellement contenus dans le message transformé. En outre, le bloc de CRC peut lui-même contenir des bits de bourrage qui peuvent empêcher la vérification.

Toutes les méthodes de vérification de CRC ou de correction du message sur la base du bloc de CRC connues présupposent que les bits de bourrage aient été éliminés du message reçu avant qu'elles puissent être appliquées, ce qui réduit fortement leur intérêt en pratique.

### Objet de l'invention

Un objet de la présente invention est de proposer un procédé de décodage qui permette la correction de bits erronés sur la base du CRC, le cas échéant même en présence de bits de bourrage.

### Description générale de l'invention

Le procédé selon l'invention s'applique au décodage d'une séquence de symboles, la séquence de symboles ayant été générée par le calcul d'un bloc de CRC sur un message initial, l'assemblage du message initial et du bloc de CRC pour ainsi produire un message transformé et l'encodage du message transformé. Le décodage comporte la construction d'une pluralité d'hypothèses de chemin à travers un treillis comprenant des noeuds et des branches représentant les transitions possibles entre les noeuds ainsi que la sélection parmi les hypothèses de chemin de l'hypothèse de chemin la plus probable par rapport à la séquence de symboles. Dans le cadre de l'invention les noeuds du treillis représentent les éléments du produit cartésien d'au moins l'ensemble des états d'un encodeur susceptible d'avoir effectué l'encodage et de l'ensemble des états d'un calculateur susceptible d'avoir calculé le bloc de CRC. Une transition d'un premier noeud, correspondant à un premier état d'encodeur et un premier état de calculateur, à un second noeud, correspondant à un second état d'encodeur et un second état de calculateur, est possible,

- en présence d'un bit de message transformé, si
  - par application de ce bit de message transformé à l'encodeur se trouvant dans le premier état d'encodeur, l'encodeur passe au second état d'encodeur, et
  - par application de ce bit de message transformé au calculateur se trouvant dans le premier état de calculateur, le calculateur passe au second état de calculateur.

Il est donc proposé d'utiliser un treillis «étendu» dont les noeuds ne représentent pas seulement les différents états de l'encodeur mais aussi les états du calculateur du bloc de CRC. En d'autres mots, le treillis « étendu » correspond au treillis d'une machine à états finis comprenant l'encodeur et le calculateur de CRC, et dans laquelle, l'encodeur et le calculateur de CRC sont alimentés par la même entrée, c.-à-d. changent d'états en fonction de la même séquence binaire appliquée en entrée.

Dans le procédé selon l'invention, et dans le cas de l'utilisation de l'algorithme de Viterbi, ou encore de l'algorithme SOVA, on retient comme hypothèse de chemin celle qui représente la séquence d'états de l'encodeur et du calculateur de CRC la plus probable. L'hypothèse de chemin la plus probable est normalement celle qui présente la distance (p.ex. de Hamming ou euclidienne) la plus faible par rapport à la séquence de symboles. Dans le cas de l'utilisation de l'algorithme BCJR, ou encore de l'algorithme BCJR simplifié, on retient comme hypothèse les bits reçus les plus probables à partir des probabilités calculées par l'algorithme BCJR ou BCJR simplifié.

Le procédé selon l'invention peut être adapté au cas où des bits de bourrage auraient été insérés, avant le codage, dans le paquet de données (le message transformé) contenant le message initial et le bloc de CRC. Dans ce cas, certaines des branches du treillis représentent des transitions conditionnelles empruntables uniquement en présence d'un bit de bourrage. Une transition d'un premier noeuds (correspondant à un premier état d'encodeur et un premier état de calculateur de CRC) à un second noeuds (correspondant à un second état d'encodeur et un second état de calculateur de CRC) du treillis est en outre possible (cas d'une transition conditionnelle) :

  ◦ en présence d'un bit de bourrage, si

    - par application de ce bit de bourrage à l'encodeur se trouvant dans le premier état d'encodeur, l'encodeur passe au second état d'encodeur, et
    - le premier état de calculateur est égal au second état de calculateur.

Cette transition tient compte du fait qu'un bit de bourrage aura entraîné, à l'encodage, un changement d'état de l'encodeur (identique au changement d'état qu'aurait subi l'encodeur en présence d'un bit d'information ou de CRC de même valeur que le bit de bourrage), tandis que les bits de bourrage n'ont aucun impact sur l'état du calculateur de CRC.

De préférence, lors de l'exécution du procédé, au fur et à mesure qu'une hypothèse de chemin est construite, un bit de bourrage est considéré détecté si les conditions selon lesquelles l'insertion d'un bit de bourrage est effectuée sont remplies. Si, par exemple, un bit de bourrage a été inséré immédiatement derrière chaque séquence de cinq bits consécutifs de valeur 1 avant la transmission du message, dans chaque hypothèse de chemin un bit qui suit immédiatement une séquence de cinq bits consécutifs de valeur 1 est considéré représenter un bit de bourrage.

De préférence, une variable d'état est associée à chaque hypothèse de chemin, qui est mise à jour, au fur et à mesure que l'hypothèse de chemin est construite, en fonction de la partie déjà construite de l'hypothèse de chemin. On surveille alors la variable d'état pour déterminer si les conditions selon lesquelles l'insertion d'un bit de bourrage est effectuée sont remplies. Par exemple, cette variable d'état peut indiquer pour chaque hypothèse de chemin le nombre de bits consécutifs de la même valeur. Dans l'exemple où l'insertion d'un bit de bourrage a lieu derrière un bit sous condition que ce bit soit précédé d'une séquence de cinq bits de valeur 1, il convient de surveiller lors de la progression d'une hypothèse de chemin à travers le treillis une variable qui indique combien de bits de valeur 1 ont précédé immédiatement le bit actuel. Dès que cette variable atteint la valeur 5, on déduit que le prochain bit est un bit de bourrage et on choisit la transition conditionnelle y relative.

Il est possible que le message initial contienne un ou plusieurs bits de redondance (p.ex. un bloc de CRC qui ne soit pas utilisé lors du décodage proprement dit) sur la base desquels on peut vérifier après le décodage si le message obtenu grâce à l'hypothèse de chemin sélectionnée ne contient pas d'erreur. Si le message initial contient un bloc de CRC, celui-ci ne doit pas avoir été calculé à l'aide du même polynôme générateur que celui qui est rajouté pour donner le message transformé. Sinon, ce dernier sera toujours égal à 0 du fait de l'application de $CRC([données, CRC(données)]) = 0$.

Il sera apprécié que le procédé selon l'invention puisse être utilisé pour la correction de messages AIS. La séquence de symboles est alors obtenue à partir d'un signal AIS, par exemple reçu par un satellite, notamment par un satellite en orbite basse. Le signal AIS est éventuellement reçu en collision avec d'autres signaux AIS (c.-à-d. qui sont reçus simultanément ou qui se chevauchent dans le temps). Dans ce cas, le procédé selon l'invention est avantageusement combiné avec des méthodes de « décollision » et de démodulation des signaux AIS, par exemple la méthode SIC (de l'anglais « Successive Interference Cancellation ») ou la formation de faisceau déterministe ou adaptative. Une méthode pour générer plusieurs « candidats de message AIS » à partir de signaux AIS en collision est décrite dans le document US 2008/0304597. Ces candidats pourraient être utilisés en tant que séquences de symboles dans le procédé selon l'invention. Notons aussi que ce dernier peut être utilisé au niveau d'un récepteur à bord d'un satellite ou au sol.

Un aspect de l'invention concerne un programme d'ordinateur contenant des instructions entraînant la mise en oeuvre du procédé décrit ci-dessus lorsque le programme d'ordinateur est exécuté par un ordinateur. Le programme d'ordinateur peut faire partie d'un produit de programme d'ordinateur qui comprend un support de données (p.ex. un disque dur, une mémoire flash, une clé USB, un CD, un DVD, une mémoire vive, etc.) sur lequel le programme est stocké.

Un autre aspect de l'invention concerne un décodeur configuré, p.ex. à l'aide d'un programme d'ordinateur approprié, pour la mise en oeuvre du procédé de l'invention.

**Brève description des dessins**

D'autres particularités et caractéristiques de l'invention ressortiront de la description détaillée de quelques modes de réalisation avantageux présentés ci-dessous, à titre d'illustration, avec référence aux dessins annexés. Ceux-ci montrent:

Fig. 1 : un schéma de principe d'une chaîne de transmission de messages conventionnelle ;

Fig. 2: un schéma de principe d'une chaîne de transmission de messages conventionnelle avec insertion/suppression de bits de bourrage ;

Fig. 3 : une illustration de l'insertion de bits de bourrage ;

Fig. 4 : un schéma simplifié d'un décodeur pour mettre en oeuvre le procédé selon l'invention ;

Fig. 5 : une illustration de la construction du treillis étendu ;

Fig. 6 : un treillis CRC et un treillis de codage ;

Fig. 7 : une illustration de la construction des hypothèses de chemin à travers le treillis étendu associé aux treillis CRC et de codage de la figure 6 ;

Fig. 8 : une illustration de la construction d'un treillis étendu avec transitions associées à la réception d'un bit de bourrage (transitions conditionnelles) ;

Fig. 9 : un schéma de principe du côté émetteur d'une chaîne de transmission AIS ;

Fig. 10 : une représentation graphique du taux d'erreurs de paquets (PER) simulé en fonction du rapport signal à bruit pour un récepteur GMSK optimal et pour un récepteur utilisant le procédé selon l'invention ;

Fig. 11 : une représentation graphique du taux d'erreurs binaires (BER) simulé en fonction du rapport signal à bruit pour un récepteur GMSK optimal et pour un récepteur utilisant le procédé selon l'invention.

**Description d'une exécution préférée**

La figure 4 montre un schéma très simplifié d'un décodeur 30 pour mettre en oeuvre le procédé selon l'invention. Ce décodeur 30 est destiné à remplacer les étages de décodage 22 et de vérification du CRC 24 dans la chaîne de transmission conventionnelle montrée à la figure 1 (variante sans suppression de bits de bourrage) ou les étages de décodage 22, de suppression des bits de bourrage 23 et de vérification du CRC 24 (variante avec suppression de bits de bourrage).

**Variante sans suppression de bits de bourrage**

Nous allons d'abord discuter la variante du procédé sans suppression de bits bourrage (applicable uniquement si l'insertion de bits de bourrage n'est pas prévue dans le protocole de transmission).

Comme indiqué plus haut, le procédé utilise un treillis « étendu » dont les noeuds ne représentent pas seulement les différents états de l'encodeur mais aussi les états du calculateur du bloc de CRC. Il est bien connu d'utiliser, p.ex. dans le contexte de l'algorithme de Viterbi, un treillis représentant les états et les transitions de l'encodeur. Par contre, à la connaissance de l'inventeur, un treillis associé au calculateur de CRC (en bref « treillis CRC ») n'a jusqu'ici jamais été utilisé dans le cadre du décodage d'une séquence de symboles et de la correction d'erreurs de transmission y relative. Il convient donc d'expliquer ce qu'on entend par « treillis CRC ».

Un bloc de CRC peut être calculé de manière itérative au moyen d'un registre à décalage à rétroaction linéaire associé au polynôme générateur. Le registre est initialisé (normalement avec la séquence [00...0] ou [11...1], bien que tout autre état initial du registre puisse être convenu par protocole). Le message initial est appliqué bit par bit au registre, suivi par autant de zéros que le registre contient de cellules. L'état final ainsi obtenu correspond au bloc de CRC, qui est rattaché au message initial. Les états intermédiaires du calculateur de CRC (le registre à décalage à rétroaction linéaire associé au polynôme générateur du CRC) peuvent être censés représenter des états (noeuds) du treillis CRC. Ces états sont interconnectés par des transitions (branches) qui relient un premier état de calculateur de CRC à un second état de calculateur auquel on arrive en appliquant un nouveau bit en entrée du calculateur lorsque celui-ci se trouve dans le premier état.

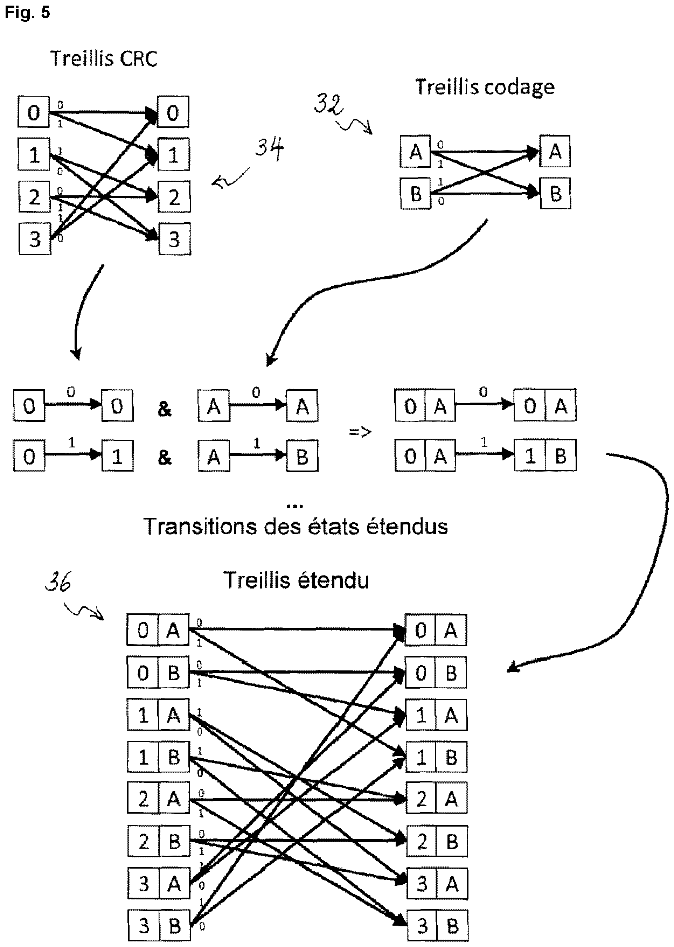

La figure 5 est une illustration de la construction d'un treillis étendu 36 à partir d'un treillis de codage 32 et d'un treillis CRC 34. Le treillis CRC 34 correspond à un cas où le calculateur de CRC peut se trouver dans quatre états différents, numérotés 0, 1, 2 et 3. Les flèches partant de chaque état correspondent aux branches du treillis CRC et indiquent l'état suivant du calculateur de CRC selon que le bit y appliqué en entrée est zéro ou un. Le treillis de codage 32 est à deux états.

Le treillis « étendu » correspond au treillis d'une machine à états finis comprenant l'encodeur et le calculateur de CRC, dans laquelle l'encodeur et le calculateur de CRC sont alimentés par la même entrée, c.-à-d. changent d'états selon la même séquence binaire appliquée en entrée. L'ensemble des noeuds du treillis étendu correspond donc au produit cartésien {(0; *A*), (0 ; *B*), (1 ; *A*),..., (3 ; *B*)} de l'ensemble des noeuds du treillis CRC {0, 1, 2, 3} et de l'ensemble des noeuds du treillis de codage {*A, B*}. Une transition entre un premier noeuds (*α; X*), correspondant à un premier état de calculateur $\alpha \in$ {0, 1, 2, 3} et un premier état d'encodeur $X \in$ {*A, B*}, à un second noeuds (*β; Y*), correspondant à un second état de calculateur $\beta \in$ {0, 1, 2, 3} et un second état d'encodeur $Y \in$ {*A, B*} est possible si les transitions $\alpha \rightarrow \beta$ et $X \rightarrow Y$ *du* treillis CRC, respectivement du treillis de codage, sont engendrées par le même bit (0 ou 1) appliqué en entrée. P.ex. si l'état *Y* (respectivement *Z*) du treillis de codage suit à l'état *X* lorsque le bit transmis est 0 (respectivement 1) et l'état $\beta$ (respectivement $\gamma$) du treillis CRC suit à l'état $\alpha$ lorsque le bit transmis est 0 (respectivement 1), alors l'état (*β; Y*) (respectivement (*γ; Z*)) suit à l'état (*α; X*) lorsque le bit transmis est 0 (respectivement 1). Sur la figure 5, le bit qui engendre une transition est à chaque fois placé près de la flèche qui la représente.

Le nombre d'états du treillis étendu s'élève au produit des nombres de noeuds du treillis de codage et du treillis CRC. Notamment le treillis CRC peut présenter un nombre très élevé de noeuds. Il existe, p.ex. des blocs de CRC à 64 bits, ce qui correspond à un treillis CRC avec $2^{64}$ états possibles.

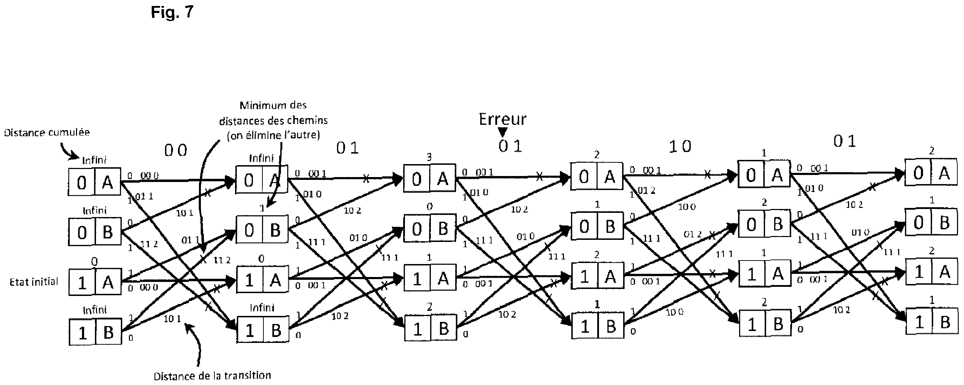

Pour expliquer le déroulement d'un mode de réalisation du procédé inventif basé sur l'algorithme de Viterbi, le CRC le plus court possible (1 bit) a été choisi afin de pouvoir graphiquement illustrer la construction des hypothèses de chemin à travers le treillis (voir figure 7). Les treillis de CRC et de codage choisis dans l'exemple sont montrés à la figure 6.

On suppose que le message initial est représenté par la séquence binaire [0 1 10]. Le bloc de CRC calculé pour ce message initial est [1]. Ce bloc de CRC correspond au bit de parité, qui indique si le nombre de uns dans le message initial est pair. Le paquet de données (message transformé) obtenu par concaténation du message initial et du bloc de CRC est [01101].

Par application du treillis de codage de la figure 6, le codage de [0 1 101] donne la séquence de symboles [00 01 11 10 1]. On ajoute une erreur d'un bit au niveau du troisième symbole pour illustrer que la correction se fait. La séquence de symboles à l'entrée du décodeur est présumée être [00 01 01 10 01].

La figure 7 montre la construction des hypothèses chemin à travers le treillis étendu selon l'algorithme de Viterbi. Les états initiaux du calculateur de CRC et de l'encodeur sont connus au décodage. On peut donc dès le départ exclure les hypothèses de chemin qui ne prennent pas le départ à l'état (1 ; *A*). Alternativement, on attribue aux hypothèses de chemin prenant le départ à un état différent de l'état initial une distance infinie (solution retenue dans la représentation de la figure 7). De cette manière, on s'assure que ces hypothèses de chemin seront éliminées lors de la progression à travers le treillis. La figure 7 montre à côté de chaque transition le symbole auquel correspond cette transition. L'indication de symbole est suivie de la distance (de Hamming) entre le symbole observé et le symbole auquel correspond la transition. A chaque fois que des hypothèses de chemin arrivent au même noeuds du treillis, seule celle qui présente la distance cumulée la plus basse survit. Les autres hypothèses de chemin sont éliminées. A la figure 7, les hypothèses de chemin éliminées sont marquées par une croix et la distance cumulée de l'hypothèse de chemin survivante est notée au-dessus du noeuds concerné. Dans la suite, on note $\Gamma(k, (\alpha; X))$ la distance cumulée à l'état (*α; X*) à l'instant *k*.

Quand l'état final est atteint, on sélectionne l'hypothèse de chemin avec la distance minimale. On note que dans le cas de l'exemple les hypothèses de chemin arrivant aux noeuds (0 ; *B*) et (1 ; *B*) possèdent la même distance minimale 1. Ici, on utilise la propriété : *CRC*([*données, CRC(données)*]) = 0, puisqu'il découle de celle-ci que l'état final du calculateur de CRC doit être 0. On retient donc l'hypothèse de chemin aboutissant à l'état (0 ; *B*). Le message trouvé est donc [0 1 1 0 1]. L'erreur de transmission a été corrigée.

## Variante avec suppression de bits de bourrage

Le procédé de l'exemple qui vient d'être discuté ne saurait être appliqué sans modifications dans le cas où des bits de bourrage auraient été insérés après le calcul du bloc de CRC.

Pour tenir compte de la présence (éventuelle) de bits de bourrage, des transitions spéciales sont introduites dans le treillis étendu. Ces transitions sont empruntées lorsqu'un bit de bourrage est reçu et sont définies de manière à ce que les bits de bourrages soient pris en compte au même titre que les bits d'information ou de CRC pour la succession des états de l'encodeur tandis que l'état du calculateur de CRC reste inchangé lorsque le bit reçu est un bit de bourrage.

Dans la suite, nous supposerons que l'insertion de bits de bourrage est effectuée comme le prévoit le protocole HDLC, c.-à-d. qu'un bit de bourrage de valeur 0 est inséré immédiatement après chaque séquence de cinq bits consécutifs de valeur 1. Notons que ce choix est fait uniquement afin de pouvoir illustrer l'invention dans le cadre d'un exemple concret. L'homme du métier n'aura aucune difficulté à adapter le procédé de l'invention à d'autres schémas d'insertion de bits de bourrage.

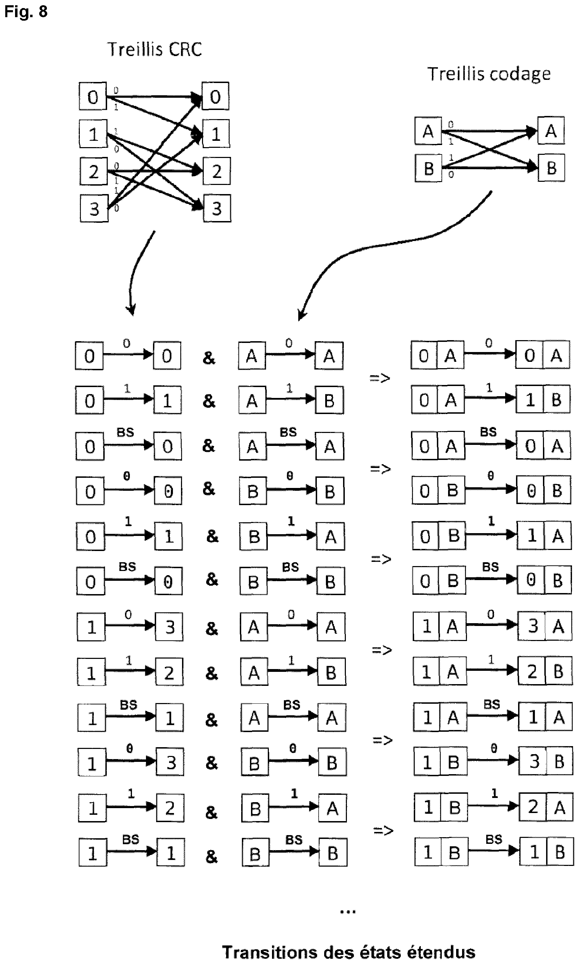

La construction d'un treillis étendu à transitions conditionnelles de bits de bourrage à partir d'un treillis CRC et d'un treillis de codage est illustrée à la figure 8. Les treillis de CRC et de codage sont les mêmes qu'à la figure 5. L'ensemble des noeuds du treillis étendu correspond de nouveau au produit cartésien {(0 *A*), (0 ; *B*), (1 ; *A*),..., (3 ; *B*)} de l'ensemble des noeuds du treillis CRC {0, 1, 2, 3} et de l'ensemble des noeuds du treillis de codage {*A*, *B*}. On peut maintenant faire la distinction entre les transitions associées aux bits d'information ou de CRC (du paquet de données) et les transitions conditionnelles associées aux bits de bourrage. Les transitions associées aux bits d'information ou de CRC sont les mêmes qu'à la figure 5. Une transition associée à un bit d'information ou de CRC d'un premier noeuds ($\alpha$; *X*), correspondant à un premier état de calculateur $\alpha \in \{0, 1, 2, 3\}$ et un premier état d'encodeur $X \in \{A, B\}$, à un second noeuds ($\beta$; *Y*), correspondant à un second état de calculateur $\beta \in \{0, 1, 2, 3\}$ et un second état d'encodeur $Y \in \{A, B\}$ est possible si les transitions $\alpha \rightarrow \beta$ et $X \rightarrow Y$ du treillis CRC, respectivement du treillis de codage, sont engendrées par le même bit d'information ou de CRC (0 ou 1) appliqué en entrée. Une transition associée à un bit de bourrage *BS* d'un premier noeuds ($\alpha$; *X*), correspondant à un premier état de calculateur $\alpha \in \{0, 1, 2, 3\}$ et un premier état d'encodeur $X \in \{A, B\}$, à un second noeuds ($\beta$ ; *Y*), correspondant à un second état de calculateur $\beta \in \{0, 1, 2, 3\}$ et un second état d'encodeur $Y \in \{A, B\}$ est possible si $\alpha = \beta$ et si la transition $X \rightarrow Y$ du treillis de codage est possible pour un bit d'information ou de CRC ayant la même valeur que le bit de bourrage *BS*. Si l'insertion de bits de bourrage est effectuée comme prévu dans le protocole HDLC, tous les bits de bourrage auront la valeur 0.

Si l'état *Y* (respectivement *Z*) du treillis de codage suit à l'état *X* lorsque le bit transmis est un bit d'information ou de CRC de valeur 0 (respectivement 1) et l'état $\beta$ (respectivement $\gamma$) du treillis CRC suit à l'état $\alpha$ lorsque le bit transmis est un bit d'information ou de CRC de valeur 0 (respectivement 1), alors l'état ($\beta$; *Y*) (respectivement ($\gamma$, *Z*)) suit à l'état ($\alpha$; *X*) lorsque le bit transmis est un bit d'information ou de CRC de valeur 0 (respectivement 1). Ceci peut s'écrire :

$$\alpha \xrightarrow{\ 0\ } \beta \ \text{ et } \ X \xrightarrow{\ 0\ } Y \Rightarrow (\alpha \,;\, X) \xrightarrow{\ 0\ } (\beta \,;\, Y)$$

$$\alpha \xrightarrow{\ 1\ } \gamma \ \text{ et } \ X \xrightarrow{\ 1\ } Z \Rightarrow (\alpha \,;\, X) \xrightarrow{\ 1\ } (\gamma \,;\, Z)$$

En présence d'un bit de bourrage *BS* (de valeur 0) on a dans ce cas les transitions :

$$\alpha \xrightarrow{\ BS\ } \alpha \ \text{ et } \ X \xrightarrow{\ BS\ } Y \Rightarrow (\alpha \,;\, X) \xrightarrow{\ BS\ } (\alpha \,;\, Y).$$

Les transitions conditionnelles ne sont empruntées dans le treillis que si un bit de bourrage est reçu. Afin de surveiller l'apparition de bits de bourrage au cours de la construction d'une hypothèse de chemin, on introduit une variable d'état $P(k, (\alpha \,;\, X))$ associée à chaque état ($\alpha$; *X*) (dans l'exemple, $\alpha$ = 0, 1, 2 ou 3 et *X=A* ou *B*) à « l'instant » *k*. *k* indique le nombre d'états (de noeuds) parcourus sur le treillis avant d'arriver à l'état considéré via l'hypothèse de chemin survivante. $P(k, (\alpha \,;\, X))$ indique le nombre de bits consécutifs de valeur 1 reçus immédiatement avant d'atteindre l'état ($\alpha \,;\, X$) à l'instant *k*. Une autre variable d'état $S(k, (\alpha; X))$ est introduite qui indique le nombre total de bits de bourrage rencontrés sur le treillis avant d'arriver à l'instant *k* à l'état ($\alpha$; *X*) via l'hypothèse de chemin survivante. Le nombre *S* de l'hypothèse de chemin finalement retenue permettra de déduire le nombre de bits d'information et de CRC reçus.

| *k* | Bit reçu | *k* + 1 |
|---|---|---|
| ($\alpha$ ; *X*) $P_k < 5$, $S_k$ | $\xrightarrow{\ 0\ }$ | ($\beta$; *Y*) $P_{k+1} = 0$, $S_{k+1} = S_k$ |
| ($\alpha$, *X*) $P_k < 5$, $S_k$ | $\xrightarrow{\ 1\ }$ | ($\gamma$ ; *Z*) $P_{k+1} = P_k + 1$, $S_{k+1} = S_k$ |
| ($\alpha$ ; *X*) $P_k < 5$, $S_k$ | $\xrightarrow{\ BS\ }$ impossible ! | ($\alpha$ ; *Y*) |

(suite)

| $k$ | Bit reçu | $k + 1$ |
|---|---|---|
| $(\alpha \, ; X)$ <br> $P_k = 5, S_k$ | $\xrightarrow{\;\;0\;\;}$ <br> impossible ! | $(\beta \, ; Y)$ |
| $(\alpha \, ; X)$ <br> $P_k = 5, S_k$ | $\xrightarrow{\;\;1\;\;}$ <br> impossible ! | $(\gamma, Z)$ |
| $(\alpha \, ; X)$ <br> $P_k = 5, S_k$ | $\xrightarrow{\;\;BS\;\;}$ | $(\alpha \, ; Y)$ <br> $P_{k+1} = 0, S_{k+1} = S_k + 1$ |

Le tableau ci-dessus montre l'évolution des variables $P$ et $S$ dans les situations qui peuvent survenir. Si le bit reçu est un bit d'information ou de CRC de valeur 0, la variable $P$ est remise à zéro pour l'état atteint ; $S$ reste inchangée. Si le bit reçu est un bit d'information ou de CRC de valeur 1, la variable $P$ est augmentée d'une unité pour l'état atteint et $S$ reste de nouveau inchangée. Si le bit reçu est un bit de bourrage ($P = 5$), $P$ est remise à zéro pour l'état atteint tandis que $S$ est augmentée d'une unité.

Au cours de la construction d'une hypothèse de chemin à travers le treillis étendu, la variable P indique si le prochain bit est un bit d'information (ou de CRC) ou de bourrage. Dans notre exemple, un bit est détecté comme étant un bit bourrage à la condition nécessaire et suffisante que ce bit soit immédiatement précédé d'une séquence ininterrompue de cinq bits d'information ou de CRC de valeur 1. Si la variable P atteint 5 dans un noeuds d'une hypothèse de chemin, la prochaine transition doit être une transition associée à un bit de bourrage. Les transitions associées à un bit d'information ou de CRC sont alors impossibles. Si par contre $P < 5$ dans un noeuds d'une hypothèse de chemin, la prochaine transition doit être une transition associée à un bit d'information ou de CRC. La transition associée à un bit de bourrage est impossible à partir de cet état. En pratique, on peut exprimer l'impossibilité d'une transition en lui affectant une distance « infinie ». Une hypothèse de chemin que l'on prolonge par une transition à distance infinie dans l'algorithme de Viterbi ne pourra pas survivre et sera éliminée.

Pour choisir l'hypothèse de chemin la plus probable, on peut de nouveau utiliser la propriété que l'état final du calculateur de CRC est 0. Par contre, l'état final $\theta_{TC}^{f}$ de l'encodeur ainsi que le nombre de bits (d'information, de CRC et de bourrage) $K$ du message transmis sont a priori inconnus. On note $\hat{K}$ et $\hat{\theta}_{TC}^{f}$ les valeurs de $K$, respectivement de $\theta_{TC}^{f}$, parmi les valeurs de $K$ et de $\theta_{TC}^{f}$ possibles, qui conjointement minimisent la distance $\Gamma(K, (0 \, ; \theta_{TC}^{f}))$ :

$$(\hat{K}, \hat{\theta}_{TC}^{f}) = \operatorname*{arg\,min}_{K, \theta_{TC}^{f}} \Gamma(K, (0 \, ; \theta_{TC}^{f}))$$

avec la contrainte : $S_{\min} \le S(K, (0 \, ; \theta_{TC}^{f})) \le S_{\max}$ et $N_{\min} \le K - S(K, (0 \, ; \theta_{TC}^{f})) \le N_{\max}$, où $S_{\min}$ et $S_{\max}$ désignent respectivement le nombre minimal et le nombre maximal de bits de bourrage, et $N_{\min}$ et $N_{\max}$ respectivement le nombre minimal et le nombre maximal de bits d'information et de CRC. Ces nombres sont définis dans le cadre de l'application. P.ex., pour AIS, $S_{\min} = 0$ et $S_{\max} = 4$ et $N_{\min} = N_{\max} = 184$. $\hat{K}$ peut prendre n'importe quelle valeur entre le nombre de bits minimal $K_{\min} = N_{\min} + S_{\min}$ et le nombre de bits maximal $K_{\max} = N_{\max} + S_{\max}$.

**Exemple de programme d'ordinateur**

Un code source de programme d'ordinateur pour la mise en oeuvre du procédé selon le précédent exemple est brièvement présenté dans la suite. Les extraits de programme d'ordinateur auxquels il est fait référence figurent en annexe à la fin de la description.

Le premier extrait du programme concerne l'initialisation de variables. Dans le cadre du programme, $(A \, ; \alpha)$ désigne l'état initial du treillis étendu. $A$ (= état initial du calculateur de CRC) est initialisé conformément au protocole de communication. Dans le cas d'AIS, qui utilise du CRC-16, $A$ est initialisé à $2^{16}$-1. La distance $\Gamma(0, (A \, ; \alpha))$ est mise à zéro pour toute valeur possible de $\alpha$ (= état initial du codeur) si $\alpha$ est inconnu. Si $\alpha$ est connu, on pose: $\Gamma(0, (A \, ; \alpha)) = 0$. La variable d'état $R(k, (\theta_{CRC} \, ; \theta_{TC}))$ correspond au bit (0, 1, ou $BS$) associé à la dernière transition à l'instant $k$ de l'hypothèse de chemin survivante au noeud ($\theta_{CRC}$ ; $\theta_{TC}$).

Dans le deuxième extrait du programme, les variables de transition sont mises à jour pour chaque symbole reçu.

$x_k$ désigne le symbole reçu à l'instant $k$, $N_S$ le nombre de symboles possibles, $S_s$ le $s$-ième symbole (des $N_S$ symboles possibles), $Distance(x_k, S_s)$ est la distance entre le symbole reçu à l'instant $k$ et le symbole $S_s$. $\theta_{CRC}$ et $\theta_{TC}$ sont les états du calculateur du bloc de CRC, respectivement de l'encodeur. $N_{CRC}$ représente le nombre d'états possibles du treillis de CRC et $N_{TC}$ le nombre d'états possibles du treillis de codage. $NextS(\theta_{TC}, t)$ renvoie au numéro ($s$) du symbole lorsque l'encodeur se trouve dans l'état $\theta_{TC}$ et un bit $t$ est reçu ($t$ peut prendre les valeurs 0, 1, ou $BS$). La variable de transition $\Gamma_{trans}((\theta_{CRC}$ ; $\theta_{TC})$, $t$) est définie à l'instant $k$ comme la somme de $\Gamma(k\text{-}1, (\theta_{CRC}$ ; $\theta_{TC}))$ et la distance entre le symbole reçu à l'instant $k$ et le symbole correspondant à la transition qui part de l'état ($\theta_{CRC}$ ; $\theta_{TC}$) et qui est associée au bit $t$. La variable de transition $S_{trans}(\theta_{CRC}$ ; $\theta_{TC})$ est définie à l'instant $k$ comme $S(k\text{-} 1, (\theta_{CRC}$ ; $\theta_{TC}))$ incrémentée de un si un bit de bourrage est reçu après l'état ($\theta_{CRC}$ ; $\theta_{TC}$) à l'instant $k$. La variable de transition $P_{trans}((\theta_{CRC}$ ; $(\theta_{TC})$, $t$) est définie à l'instant $k$ comme $P(k - 1, (\theta_{CRC}$ ; $\theta_{TC}))$ incrémentée de un lorsque que l'état ($\theta_{CRC}$ ; $\theta_{TC}$) est suivi par un bit à un ($t = 1$) à l'instant $k$. Dans le cas où le bit reçu n'est pas un bit de bourrage ($t \neq BS$), les variables de transition sont mises à jour comme dans l'algorithme de Viterbi conventionnel. Dans le cas contraire, seules les transitions conditionnelles restent possibles (une distance infinie est affectée aux transitions associées à un bit d'information ou de CRC).

La troisième partie du programme s'occupe du calcul des variables d'état. La fonction $P_{rev}\theta_{CRC}(\theta_{CRC,}$ $t$) renvoie à l'état de calculateur de CRC qui précède l'état $\theta_{CRC}$ si le bit $t$ est reçu. La fonction $Prev\theta_{TC}(\theta_{TC}$, $t$) renvoie à l'état de l'encodeur auquel suit l'état $\theta_{TC}$ si le bit $t$ est reçu.

Dans le quatrième extrait, l'hypothèse de chemin optimale est retracée à travers le treillis étendu. On commence à l'état final estimé (0 ; $\hat{\theta}_{TC}^f$ ), et on détermine de manière itérative les états précédents en empruntant à chaque fois dans le sens inverse la branche de la transition ayant survécu à l'état où on se trouve actuellement. A chaque fois qu'une transition qui correspond à un bit d'information ou de CRC ($t$=0 ou 1) est empruntée, le bit correspondant est enregistré dans la variable $U_n$. La séquence ($U_n$) représente le message décodé duquel les bits de bourrage ont été supprimés.

## Résultats de simulations

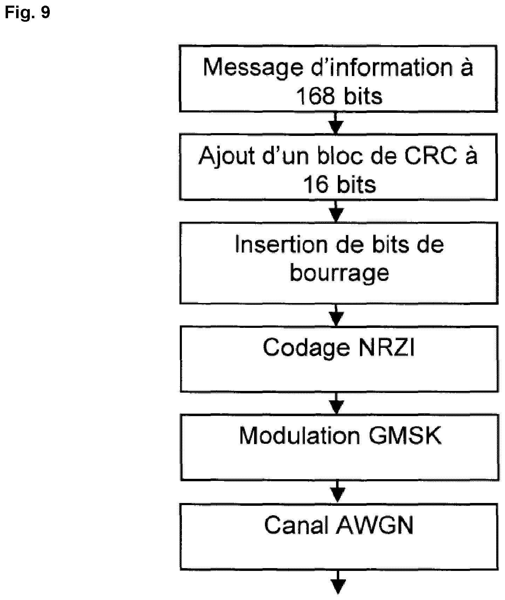

Pour illustrer la performance d'un décodeur mettant en oeuvre le procédé selon l'invention, des simulations ont été menées dans le cas d'une chaîne de transmission AIS telle qu'illustrée à la figure 9. Le message initial a une longueur fixe de 168 bits. Après ajout d'un bloc de CRC-16, des bits de bourrage sont insérés (conformément au protocole AIS après une séquence de cinq bits 1 consécutifs). La trame ainsi obtenue est encodée NRZI (de l'anglais « Non Return to Zero Inverted », codage par différentiel) et modulée GMSK (de l'anglais « Gaussian Minimum Shift Keying » ou modulation à déplacement minimum gaussien) avec les paramètres $BT$ (produit de la bande fréquentielle à -3 dB de la fonction génératrice du filtre gaussien par la période symbole) = 0,3 et $LT$ (demi-longueur du filtre gaussien) = 4. On part de l'hypothèse d'un canal de transmission AWGN (de l'anglais « Additive White Gaussian Noise » pour bruit blanc gaussien additif). Dans cet exemple, le codage NRZI et la modulation GMSK représentent le codage treillis. Selon la recommandation UIT-R M.1371 sur les caractéristiques techniques du système AIS, le polynôme générateur pour le calcul du bloc CRC est $G(x) = x^{16} + x^{12} + x^5 + 1$.

Le décodeur selon l'invention est comparé à un récepteur basé sur un démodulateur GMSK optimal utilisant la démodulation cohérente sur la base de l'algorithme de Viterbi. Dans le décodage NRZI considéré, un changement est associé au bit 0 et le bit 1 est détecté s'il n'y a pas de changement.

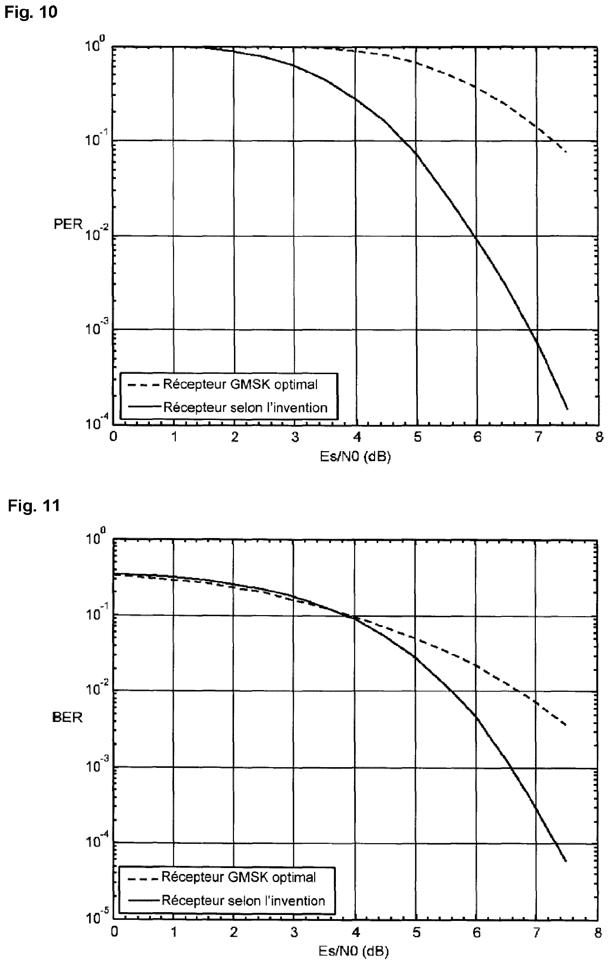

La figure 10 montre le taux d'erreurs de paquets (PER, défini comme le rapport du nombre de paquets erronés, c.-à-d. contenant au moins un bit erroné, au nombre total de paquets transmis) d'un récepteur utilisant un décodeur selon l'invention et d'un récepteur GMSK optimal en fonction du rapport signal sur bruit ($Es$/$N$0). On remarque que le récepteur proposé présente un gain de plus de 2,5 dB par rapport au récepteur GMSK optimal.

La figure 11 montre le taux d'erreurs binaires (BER, défini comme le rapport du nombre de bits erronés au nombre total de bits transmis pendant un certain laps de temps) d'un récepteur utilisant un décodeur selon l'invention et d'un récepteur GMSK optimal en fonction du rapport signal sur bruit ($Es$/$N$0). Le taux d'erreurs élevé de la figure 11 indique que le taux d'erreurs dans des messages erronés est élevé. Autrement dit, lorsqu'un message contient au moins une erreur, il en contient beaucoup en moyenne. Ceci permet d'utiliser des méthodes de vérification de la consistance des données pour déterminer si un message contient des erreurs. Pour détecter des messages erronés, l'utilisation de telles méthodes s'avère utile parce qu'on ne pourra pas se servir du bloc de CRC pour rejeter un message décodé comme erroné. Il est toutefois possible d'inclure dès le départ dans le message initial un bloc de CRC qui ne soit pas utilisé pour la correction des erreurs afin de vérifier après l'exécution du procédé selon l'invention que le message ne contient pas d'erreur. Par contre, ce CRC ne peut utiliser le même polynôme générateur que celui du CRC utilisé pour la correction des erreurs. Sinon, le second CRC sera toujours égal à 0 du fait de l'application de $CRC([$données, $CRC($don-

*nées*)]) = 0.

**Extraits de programme d'ordinateur:**

Partie 1 (initialisation)

$$\Gamma(0, (:; :)) \leftarrow \infty$$

$$\Gamma(0, (A; \alpha)) \leftarrow 0$$

$$P(0, (:; :)) \leftarrow 0$$

$$S(0, (:; :)) \leftarrow 0$$

$$R(0, (:; :)) \leftarrow 0$$

Partie 2 (calcul des variables de transition)

$$\textbf{for } s = 1 \text{ to } N_S \textbf{ do}$$
$$\quad d(s) \leftarrow Distance(x_k, S_s)$$
$$\textbf{end for}$$
$$\textbf{for } \boldsymbol{\theta}_{TC} = 0 \text{ to } N_{TC} - 1 \textbf{ do}$$
$$\quad \Gamma_{trans}((:; \boldsymbol{\theta}_{TC}), 0) \leftarrow d(NextS(\boldsymbol{\theta}_{TC}, 0))$$
$$\quad \Gamma_{trans}((:; \boldsymbol{\theta}_{TC}), 1) \leftarrow d(NextS(\boldsymbol{\theta}_{TC}, 1))$$
$$\textbf{end for}$$
$$\Gamma_{trans}((:;:), 0) \leftarrow \Gamma_{trans}((:;:), 0) + \Gamma(k-1, (:;:))$$
$$\Gamma_{trans}((:;:), 1) \leftarrow \Gamma_{trans}((:;:), 1) + \Gamma(k-1, (:;:))$$
$$\Gamma_{trans}((:;:), BS) \leftarrow \infty$$
$$P_{trans}((:;:), 0) \leftarrow 0$$
$$P_{trans}((:;:), 1) \leftarrow P(k-1, (:;:)) + 1$$
$$P_{trans}((:;:), BS) \leftarrow 0$$
$$S_{trans}((:;:)) \leftarrow S(k-1, (:;:))$$
$$\textbf{for } \boldsymbol{\theta}_{CRC} = 0 \text{ to } N_{CRC} - 1 \textbf{ do}$$
$$\quad \textbf{for } \boldsymbol{\theta}_{TC} = 0 \text{ to } N_{TC} - 1 \textbf{ do}$$
$$\quad\quad \textbf{if } P(k-1, (\boldsymbol{\theta}_{CRC}; \boldsymbol{\theta}_{TC})) = 5 \textbf{ then}$$
$$\quad\quad\quad \Gamma_{trans}((\boldsymbol{\theta}_{CRC}; \boldsymbol{\theta}_{TC}), BS) \leftarrow \Gamma_{trans}((\boldsymbol{\theta}_{CRC}; \boldsymbol{\theta}_{TC}), 0)$$
$$\quad\quad\quad \Gamma_{trans}((\boldsymbol{\theta}_{CRC}; \boldsymbol{\theta}_{TC}), 0) \leftarrow \infty$$
$$\quad\quad\quad \Gamma_{trans}((\boldsymbol{\theta}_{CRC}; \boldsymbol{\theta}_{TC}), 1) \leftarrow \infty$$
$$\quad\quad\quad S_{trans}((\boldsymbol{\theta}_{CRC}; \boldsymbol{\theta}_{TC})) \leftarrow S_{trans}((\boldsymbol{\theta}_{CRC}; \boldsymbol{\theta}_{TC})) + 1$$
$$\quad\quad \textbf{end if}$$
$$\quad \textbf{end for}$$
$$\textbf{end for}$$

Partie 3 (calcul des variables d'état)

$$\textbf{for } \theta_{CRC} = 0 \text{ to } N_{CRC} - 1 \textbf{ do}$$
$$\quad\textbf{for } \theta_{TC} = 0 \text{ to } N_{TC} - 1 \textbf{ do}$$
$$\quad\quad \sigma_{CRC}(0) \leftarrow Prev\theta_{CRC}(\theta_{CRC}, 0)$$
$$\quad\quad \sigma_{CRC}(1) \leftarrow Prev\theta_{CRC}(\theta_{CRC}, 1)$$
$$\quad\quad \sigma_{CRC}(2) \leftarrow \theta_{CRC}$$
$$\quad\quad \sigma_{TC}(0) \leftarrow Prev\theta_{TC}(\theta_{TC}, 0)$$
$$\quad\quad \sigma_{TC}(1) \leftarrow Prev\theta_{TC}(\theta_{TC}, 1)$$
$$\quad\quad \sigma_{TC}(2) \leftarrow Prev\theta_{TC}(\theta_{TC}, 0)$$
$$\quad\quad t \leftarrow \arg\min_t \Gamma_{trans}((\sigma_{CRC}(t); \sigma_{TC}(t)), t)$$
$$\quad\quad \Gamma(k, (\theta_{CRC}; \theta_{TC})) \leftarrow \Gamma_{trans}((\sigma_{CRC}(t); \sigma_{TC}(t)), t)$$
$$\quad\quad P(k, (\theta_{CRC}; \theta_{TC})) \leftarrow P_{trans}((\sigma_{CRC}(t); \sigma_{TC}(t)), t)$$
$$\quad\quad S(k, (\theta_{CRC}; \theta_{TC})) \leftarrow S_{trans}((\sigma_{CRC}(t); \sigma_{TC}(t)))$$
$$\quad\quad R(k, (\theta_{CRC}; \theta_{TC})) \leftarrow t$$
$$\quad\textbf{end for}$$
$$\textbf{end for}$$

Partie 4 (lecture du chemin)

$$\theta_{CRC} \leftarrow 0$$
$$\theta_{TC} \leftarrow \theta_{TC}^f$$
$$n \leftarrow K - S(K, (0; \theta_{TC}^f))$$
$$\textbf{for } k = K \text{ to } 1 \textbf{ do}$$
$$\quad t \leftarrow R(k, (\theta_{CRC}; \theta_{TC}))$$
$$\quad \textbf{if } t \neq BS \textbf{ then}$$
$$\quad\quad \theta_{CRC} \leftarrow Prev\theta_{CRC}(\theta_{CRC}, t)$$
$$\quad\quad \theta_{TC} \leftarrow Prev\theta_{TC}(\theta_{TC}, t)$$
$$\quad\quad U_n \leftarrow t$$
$$\quad\quad n \leftarrow n - 1$$
$$\quad \textbf{else}$$
$$\quad\quad \theta_{TC} \leftarrow Prev\theta_{TC}(\theta_{TC}, 0)$$
$$\quad \textbf{end if}$$
$$\textbf{end for}$$

**Revendications**

1. Procédé de décodage d'une séquence de symboles, la séquence de symboles ayant été générée par calcul d'un bloc de contrôle de redondance cyclique sur un message initial, assemblage du message initial et du bloc de contrôle de redondance cyclique pour produire un message appelé message transformé par la suite, insertion de bits de bourrage dans le message transformé, et encodage du message transformé dans lequel des bits de bourrage sont insérés avant l'encodage;
le décodage comprenant la construction d'une pluralité d'hypothèses de chemin à travers un treillis comprenant des noeuds et des branches, lesdites branches représentant les transitions possibles entre lesdits noeuds, ainsi que la sélection parmi lesdites hypothèses de chemin de l'hypothèse de chemin la plus probable par rapport à la séquence de symboles,

procédé dans lequel lesdits noeuds représentent les éléments d'un produit cartésien d'au moins l'ensemble des états d'un encodeur susceptible d'avoir effectué ledit encodage et de l'ensemble des états d'un calculateur susceptible d'avoir calculé le bloc de contrôle de redondance cyclique, et

dans lequel une transition d'un premier noeud, correspondant à un premier état d'encodeur et un premier état de calculateur, à un second noeud, correspondant à un second état d'encodeur et un second état de calculateur, étant possible,

   o en présence d'un bit de message transformé, si

- par application de ce bit de message transformé à l'encodeur se trouvant dans le premier état d'encodeur, l'encodeur passe au second état d'encodeur, et
- par application de ce bit de message transformé au calculateur se trouvant dans le premier état de calculateur, le calculateur passe au second état de calculateur **caractérisé en ce que** les branches du treillis comprennent des branches représentant des transitions conditionnelles empruntables uniquement en présence d'un bit de bourrage, et dans lequel une transition dudit premier noeuds audit second noeud, étant en outre possible

   ∘ en présence d'un bit de bourrage, si

- par application de ce bit de bourrage à l'encodeur se trouvant dans le premier état d'encodeur, l'encodeur passe au second état d'encodeur, et
- le premier état de calculateur est égal au second état de calculateur.

2. Procédé selon la revendication 1, dans lequel la sélection du chemin à travers le treillis est basée sur l'algorithme de Viterbi.

3. Procédé selon la revendication 1, dans lequel la sélection du chemin à travers le treillis est basée sur l'algorithme SOVA.

4. Procédé selon la revendication 1, dans lequel la sélection du chemin à travers le treillis est basée sur l'algorithme BCJR ou sur l'algorithme BCJR simplifié.

5. Procédé selon l'une quelconque des revendications 1 à 4, dans lequel, au fur et à mesure qu'une hypothèse de chemin est construite, un bit de bourrage est considéré détecté si les conditions selon lesquelles l'insertion d'un bit de bourrage est effectuée sont remplies.

6. Procédé selon la revendication 5, dans lequel une variable d'état est associée à chaque hypothèse de chemin, ladite variable d'état étant mise à jour, au fur et à mesure que l'hypothèse de chemin est construite, en fonction de la partie déjà construite de l'hypothèse de chemin, et dans lequel la variable d'état est surveillée pour déterminer si les conditions selon lesquelles l'insertion d'un bit de bourrage est effectuée sont remplies.

7. Procédé selon l'une quelconque des revendications 1 à 6, dans lequel le message initial contient un ou plusieurs bits de redondance, le procédé comprenant la vérification de l'hypothèse de chemin retenue sur la base de ce ou ces bits de redondance.

8. Procédé selon l'une quelconque des revendications 1 à 7, dans lequel la séquence de symboles est obtenue à partir d'un signal AIS, par exemple reçu par un satellite, notamment par un satellite en orbite basse.

9. Procédé selon la revendication 8, dans lequel ladite séquence de symboles est obtenue à partir d'une pluralité de signaux AIS simultanés ou se chevauchant dans le temps.

10. Programme d'ordinateur contenant des instructions entraînant la mise en oeuvre du procédé selon l'une quelconque des revendications 1 à 9 lorsque le programme d'ordinateur est exécuté par un ordinateur.

11. Décodeur configuré pour la mise en oeuvre du procédé selon l'une quelconque des revendications 1 à 9.

**Patentansprüche**

1.  Verfahren zur Decodierung einer Symbolfolge, wobei die Symbolfolge durch Berechnung eines zyklischen Redundanzprüfungsblocks auf einer ursprünglichen Nachricht, Verknüpfung der ursprünglichen Nachricht und des zyklischen Redundanzprüfungsblocks zur Erzeugung einer in der Folge geänderte Nachricht genannten Nachricht, Einfügung von Stopfbits in die geänderte Nachricht und Codierung der geänderten Nachricht erzeugt wurde, bei dem die Stopfbits vor der Codierung eingefügt werden; wobei die Decodierung die Aufstellung einer Vielzahl von Pfadhypothesen durch ein Gitter, das Knoten und Zweige aufweist, welche Zweige die möglichen Übergänge zwischen den Knoten darstellen, sowie die Auswahl derjenigen Pfadhypothese unter den Pfadhypothesen umfasst, die in Bezug auf die Symbolfolge am wahrscheinlichsten ist,
    Verfahren, bei dem die Knoten die Elemente eines kartesischen Produkts darstellen, wenigstens bestehend aus der Menge der Zustände eines Codierers, der die Codierung durchführen konnte, und der Menge der Zustände eines Rechners, der den zyklischen Redundanzprüfungsblock berechnen konnte, und
    bei dem ein Übergang von einem ersten Knoten, der einem ersten Codiererzustand und einem ersten Rechnerzustand entspricht, zu einem zweiten Knoten, der einem zweiten Codiererzustand und einem zweiten Rechnerzustand entspricht, möglich ist, wenn

    ◦ in Gegenwart eines Bits eines geänderten Nachrichts,

       - durch Anwenden dieses Bits des geänderten Nachrichts auf den sich im ersten Codiererzustand befindlichen Codierer der Codierer in den zweiten Codiererzustand wechselt, und
       - durch Anwenden dieses Bits des geänderten Nachrichts auf den sich im ersten Rechnerzustand befindlichen Rechner der Rechner in den zweiten Rechnerzustand wechselt,

    **dadurch gekennzeichnet, dass**
    die Zweige des Gitters Zweige umfassen, die bedingte, nur in Gegenwart eines Stopfbits benutzbare Übergänge darstellen, und bei dem ein Übergang vom ersten Knoten zum zweiten Knoten zudem möglich ist, wenn
    ◦ in Gegenwart eines Stopfbits

       - durch Anwenden dieses Stopfbits auf den sich im ersten Codiererzustand befindlichen Codierer der Codierer in den zweiten Codiererzustand wechselt, und
       - der erste Rechnerzustand gleich dem zweiten Rechnerzustand ist.

2.  Verfahren nach Anspruch 1, bei dem die Auswahl des Pfads durch das Gitter auf dem Viterbi-Algorithmus basiert.

3.  Verfahren nach Anspruch 1, bei dem die Auswahl des Pfads durch das Gitter auf dem SOVA-Algorithmus basiert.

4.  Verfahren nach Anspruch 1, bei dem die Auswahl des Pfads durch das Gitter auf dem BCJR-Algorithmus oder dem vereinfachten BCJR-Algorithmus basiert.

5.  Verfahren nach irgendeinem der Ansprüche 1 bis 4, bei dem beim Aufstellen einer Pfadhypothese ein Stopfbit als erfasst betrachtet wird, wenn die Bedingungen, nach denen die Einfügung eines Stopfbits erfolgt, erfüllt sind.

6.  Verfahren nach Anspruch 5, bei dem jeder Pfadhypothese eine Zustandsvariable zugeordnet wird, wobei die Zustandsvariable beim Aufstellen der Pfadhypothese in Abhängigkeit von dem bereits aufgestellten Teil der Pfadhypothese aktualisiert wird, und bei dem die Zustandsvariable überwacht wird, um festzustellen, ob die Bedingungen, nach denen die Einfügung eines Stopfbits erfolgt, erfüllt sind.

7.  Verfahren nach irgendeinem der Ansprüche 1 bis 6, bei dem die ursprüngliche Nachricht ein oder mehrere Redundanzbits enthält, wobei das Verfahren die Prüfung der gewählten Pfadhypothese auf der Basis des oder der Redundanzbits umfasst.

8.  Verfahren nach irgendeinem der Ansprüche 1 bis 7, bei dem die Symbolfolge aus einem AIS-Signal erhalten wird, welches beispielsweise von einem Satelliten, insbesondere von einem erdnahen Satelliten empfangen wird.

9.  Verfahren nach Anspruch 8, bei dem die Symbolfolge aus einer Vielzahl gleichzeitiger oder sich zeitlich überschneidender AIS-Signale erhalten wird.

10. Computerprogramm, enthaltend Anweisungen zur Durchführung des Verfahrens nach irgendeinem der Ansprüche 1 bis 9, wenn das Computerprogramm von einem Computer ausgeführt wird.

11. Decoder, ausgebildet für die Durchführung des Verfahrens nach irgendeinem der Ansprüche 1 bis 9.

**Claims**

1. Method for decoding a sequence of symbols, said sequence of symbols having been generated by calculating a cyclic redundancy check value for an initial message, combining the initial message and the cyclic redundancy check value to produce a message, hereinafter called transformed message, inserting stuffing bits into the transformed message, and encoding the transformed message in which the stuffing bits are inserted prior to the encoding; the decoding comprising the generation of a plurality of path hypotheses across a trellis comprising nodes and branches, said branches representing the possible transitions between said nodes, as well as the selection of the most probable path hypothesis from said path hypotheses, with respect to the sequence of symbols,
method in which said nodes represent the elements of a Cartesian product of at least the set of encoder states likely to have performed said encoding and the set of calculator states likely to have calculated the cyclic redundancy check value, and
in that a transition from a first node, corresponding to a first encoder state and a first calculator state, to a second node, corresponding to a second encoder state and a second calculator state, is possible,

   ∘ in the presence of a bit of transformed message, if

   - on applying this bit of transformed message to the encoder that is in the first encoder state, the encoder then passes to the second encoder state, and
   - on applying this bit of transformed message to the calculator that is in the first calculator state, the calculator passes to the second calculator state

   **characterised in that**
   the branches of the trellis comprise branches representing conditional transitions that can be used solely in the presence of a stuffing bit, and in which a transition from said first node to said second node being moreover possible
   ∘ in the presence of a stuffing bit, if

   - on applying this stuffing bit to the encoder that is in the first encoder state, the encoder then passes to the second encoder state, and
   - the first calculator state is equal to the second calculator state.

2. Method according to claim 1, wherein the selection of the path across the trellis is based on the Viterbi algorithm.

3. Method according to claim 1, wherein the selection of the path across the trellis is based on the SOVA algorithm.

4. Method according to claim 1, wherein the selection of the path across the trellis is based on the BCJR algorithm or on the simplified BCJR algorithm.

5. Method according to one of claims 1 to 4, wherein as a path hypothesis is being constructed, a stuffing bit is considered detected if the conditions according to which the insertion of a stuffing bit is performed are met.

6. Method according to claim 5, wherein a state variable is associated with each path hypothesis, said state variable being updated as the path hypothesis is being constructed depending on the already constructed path of the path hypothesis, and in which the state variable is monitored to determine if the conditions in which the insertion of a stuffing bit is performed are met.

7. Method according to any one of claims 1 to 6, wherein the initial message contains one or several redundancy bits, the method comprising the verification of the path hypothesis that was retained based on this or these redundancy bits.

8. Method according to any one of claims 1 to 7, wherein the sequence of symbols is obtained from an AIS signal, for example received by a satellite, in particular by a low earth orbit satellite.

9. Method according to claim 8, wherein said sequence of symbols is obtained from a plurality of simultaneous or time-overlapping AIS signals.

10. Computer programme containing instructions causing the implementation of the method according to any one of claims 1 to 9 when the computer programme is executed by a computer.

11. Decoder configured for implementing the method according to any one of claims 1 to 9.

EP 2 661 814 B1

**Fig. 1 (état de la technique)**

Message d'information ~ 10

↓

Ajout CRC ~ 12

↓

Codage treillis ~ 14

↓

Modulation ~ 16

↓

Canal ~ 18

↓

Démodulation ~ 20

↓

Décodage ~ 22

↓

Vérification CRC ~ 24

↓

Sortie du message ~ 26

**Fig. 2 (état de la technique)**

```
┌─────────────────────────────┐
│    Message d'information     │ ~ 10
└─────────────────────────────┘
              ↓
┌─────────────────────────────┐
│          Ajout CRC           │ ~ 12
└─────────────────────────────┘
              ↓
┌─────────────────────────────┐
│     Insertion de bits de     │ ~ 13
│           bourrage           │
└─────────────────────────────┘
              ↓
┌─────────────────────────────┐
│        Codage treillis       │ ~ 14
└─────────────────────────────┘
              ↓
┌─────────────────────────────┐
│          Modulation          │ ~ 16
└─────────────────────────────┘
              ↓
┌─────────────────────────────┐
│            Canal             │ ~ 18
└─────────────────────────────┘
              ↓
┌─────────────────────────────┐
│         Démodulation         │ ~ 20
└─────────────────────────────┘
              ↓
┌─────────────────────────────┐
│           Décodage           │ ~ 22
└─────────────────────────────┘
              ↓
┌─────────────────────────────┐
│    Suppression des bits de   │ ~ 23
│           bourrage           │
└─────────────────────────────┘
              ↓
┌─────────────────────────────┐
│       Vérification CRC       │ ~ 24
└─────────────────────────────┘
              ↓
┌─────────────────────────────┐
│       Sortie du message      │ ~ 26
└─────────────────────────────┘
```

**Fig. 3 (état de la technique)**

5 uns consécutifs

| 0 | 1 | 0 | 1 | 1 | 1 | 1 | 1 | 1 | 1 | 0 | 0 | 1 | 1 | 0 | 0 | 0 | 0 |

Ajout de bit(s) de bourrage

| 0 | 1 | 0 | 1 | 1 | 1 | 1 | 1 | 0 | 1 | 1 | 0 | 0 | 1 | 1 | 0 | 0 | 0 | 0 |

**Fig. 4**

Séquence d'observation (ou séquence de symboles)

Treillis CRC

Treillis codage

Treillis « étendu »

*30*

Algorithme de Viterbi (éventuellement à transitions conditionnelles)

**Fig. 6**

Treillis CRC
Etat initial : 1

0 → 0
1

1 → 1
0

Treillis codage
Etat initial : A

A → A
0   00
1   01
      10
B → B
0   11
1

**Fig. 5**

Treillis CRC

Treillis codage

*32*

*34*

...
Transitions des états étendus

*36*

Treillis étendu

**Fig. 7**

**Fig. 8**

Treillis CRC

Treillis codage

**Transitions des états étendus**

**Fig. 9**

```
┌─────────────────────────┐
│  Message d'information à │
│        168 bits          │
└─────────────────────────┘
             │
             ▼
┌─────────────────────────┐
│  Ajout d'un bloc de CRC à│
│        16 bits           │
└─────────────────────────┘
             │
             ▼
┌─────────────────────────┐
│   Insertion de bits de   │
│        bourrage          │
└─────────────────────────┘
             │
             ▼
┌─────────────────────────┐
│      Codage NRZI         │
└─────────────────────────┘
             │
             ▼
┌─────────────────────────┐
│    Modulation GMSK       │
└─────────────────────────┘
             │
             ▼
┌─────────────────────────┐
│      Canal AWGN          │
└─────────────────────────┘
             │
             ▼
```

**Fig. 10**

PER

Es/N0 (dB)

- - - Récepteur GMSK optimal
—— Récepteur selon l'invention

**Fig. 11**

BER

Es/N0 (dB)

- - - Récepteur GMSK optimal
—— Récepteur selon l'invention

## RÉFÉRENCES CITÉES DANS LA DESCRIPTION

**Documents brevets cités dans la description**

• US 20080304597 A

**Littérature non-brevet citée dans la description**

• **B. MCDANIEL.** An algortithm for error correcting cyclic redundance checks. *C/C++ Users Journal,* 2003, 6
• Double bits error correction using CRC method. **S. BABAIE ; A. K. ZADEH ; S. H. ES-HAGI ; N. J. NVIMIPOUR.** International Conférence on Semantics. Knowledge and Grid, 2009, 254-257

• **C. SHI-YI ; L. YU-BAI.** Error correcting cycle redundancy checks based on confidence declaration. *ITS Télécommunications Proceedings,* 2006, vol. 6, 511-514
• **G. BOLLATI et al.** A 450 Mbit/s parallel read/write channel with parity check and 16-state time variant Viterbi. *Proceedings og the IEEE 2000 Custom Integrated Circuits Conference, CICC 2000,* 21 Avril 2000, vol. 22, 319-322